# DEMANDE DE BREVET EUROPEEN

(11) **EP 2 961 249 A1**
(43) Date de publication de la demande: **30.12.2015**
(21) Numéro de dépôt: 15168789.4
(22) Date de dépôt: 22.05.2015
(51) Int. Cl.: H05K 1/02, H01H 50/04, H01P 1/12, H01P 1/10, H05K 5/02, H05K 1/18

(54) **ENSEMBLE COMPRENANT UN COMPOSANT HYPERFRÉQUENCE ET UN CIRCUIT IMPRIMÉ**

(30) Priorité: 23.05.2014 FR 1454676
(71) Demandeur: RADIALL, 93300 Aubervilliers (FR)
(72) Inventeur: Flaceau, Alexandre, 69007 Lyon (FR); Fond, Emilie, 38210 Tullins (FR)
(74) Mandataire: Myon, Gérard Jean-Pierre

(57) **Abrégé**

Cet ensemble (1) comprend un composant (2) hyperfréquence de type composant monté en surface comportant au moins une première ligne de transmission hyperfréquence (3), ainsi qu'une carte (4) de circuit imprimé comportant au moins une deuxième ligne de transmission hyperfréquence (7) apte à être connectée à la première ligne de transmission hyperfréquence. Le composant (2) comprend un boîtier (20) ayant une face (202) en contact avec la carte de circuit imprimé (4), qui comporte au moins une cavité de confinement d'un signal hyperfréquence, délimitée par des surfaces conductrices du boîtier, et par une zone conductrice (73) de la deuxième ligne de transmission hyperfréquence (7). La zone conductrice (73) de la deuxième ligne de transmission hyperfréquence (7) referme au moins en partie un renfoncement (5) du boitier, délimité par la surface conductrice pour former la cavité.

## Description

La présente invention concerne un ensemble comprenant un composant hyperfréquence ainsi qu'un circuit imprimé.

Un composant électronique est dit « hyperfréquence » lorsqu'il est capable de fonctionner dans la gamme des hyperfréquences, c'est-à-dire à des fréquences comprises entre 1 GHz et plusieurs dizaines de GHz, par exemple de l'ordre de 60 GHz.

Les composants électroniques de type C.M.S. (composant monté en surface) sont brasés à la surface d'une carte électronique, au lieu d'inclure des broches qui passent au travers de la carte électronique. Les composants C.M.S. ont des terminaisons métalliques ou broches à leurs extrémités pour pouvoir être brasés directement à la surface des circuits imprimés.

Lorsqu'un signal hyperfréquence se propage de la ligne hyperfréquence d'un circuit imprimé vers l'entrée, généralement coaxiale, d'un boîtier d'un composant C.M.S, une désadaptation importante entre les deux différents types de lignes de transmission provoque de fortes perturbations, notamment en créant des inductances ou des capacités parasites. Cette désadaptation s'accompagne généralement de pertes ou de réflexions hyperfréquence, ce qui limite la fréquence maximale d'utilisation du composant. De plus, une mauvaise gestion de la propagation du signal entre le circuit imprimé et le composant, ainsi qu'entre les entrées adjacentes du composant, provoque un défaut d'isolation entre ces entrées, ce qui entraine un couplage des entrées et limite également la fréquence maximale du composant.

Il est connu d'une brochure technique de la société TELEDYNE datée de 2007 et portant la référence SGRF100/SGRF103 un relais de type C.M.S. comportant plusieurs voies à la base du composant. Des parois d'isolation sont positionnées entre les voies. La broche qui termine la tige conductrice centrale de chaque voie est recourbée pour être brasée sur une carte de circuit imprimé, et dépasse à l'extérieur d'un boîtier du relais. Une perle de verre maintient la tige dans le boîtier du relais au niveau de la traversée du boîtier. La perle de verre ne permet pas d'optimiser le signal à des hautes fréquences car elle crée une désadaptation de la ligne et génère des pertes, limitant la montée en fréquence. Par ailleurs, la section de la tige conductrice centrale est constante et non modulable, ce qui limite l'optimisation de l'adaptation hyperfréquence dans cette zone. Aucune précaution n'est recommandée pour empêcher le couplage des voies au niveau du circuit imprimé. Il existe donc des fuites de signal hyperfréquence à travers le circuit imprimé. L'isolation entre les voies est donc imparfaite. La transmission du signal entre le circuit imprimé et la partie active du relais n'est pas optimisée, ce qui limite la montée en fréquence.

Le document US 6 809 255 B1 peut être considéré comme l'état de la technique le plus proche, conforme au préambule de la revendication 1.

C'est à ces inconvénients qu'entend plus particulièrement remédier l'invention en proposant un ensemble comprenant un composant hyperfréquence de type C.M.S. et une carte de circuit imprimé, avec une transition améliorée entre la carte de circuit imprimé et le composant. Un autre but de l'invention est de proposer une isolation améliorée entre les voies hyperfréquence, de manière à fiabiliser le fonctionnement du composant à fréquence élevée.

A cet effet, l'invention a pour objet un ensemble comprenant un composant hyperfréquence de type composant monté en surface comportant au moins une première ligne de transmission hyperfréquence, ainsi qu'une carte de circuit imprimé comportant au moins une deuxième ligne de transmission hyperfréquence apte à être mise en contact avec la première ligne de transmission hyperfréquence. Le composant comprend un boîtier ayant une face en contact avec la carte de circuit imprimé, qui comporte au moins une cavité de confinement d'un signal hyperfréquence, délimitée par au moins une surface conductrice du boîtier, et par une zone conductrice reliée à la masse de la deuxième ligne de transmission hyperfréquence du circuit imprimé, la zone conductrice refermant au moins en partie un renfoncement du boitier délimité par la surface conductrice pour former la cavité.

Grâce à l'invention, le signal hyperfréquence est guidé dans la cavité ménagée sous le boîtier du composant. Ainsi, les pertes et les fuites du signal occasionnées par le passage du signal entre la carte et le composant sont réduites.

De plus, la cavité est formée par l'assemblage du boîtier, délimitant le renfoncement, et de la carte portant la zone conductrice. La réalisation de l'ensemble est donc aisée.

Selon des aspects avantageux mais non obligatoires de l'invention, un tel ensemble peut incorporer une ou plusieurs des caractéristiques techniques suivantes, prises dans toute combinaison techniquement admissible :
- Le boîtier est réalisé à partir d'un matériau conducteur et les surfaces conductrices du renfoncement sont métalliques.
- La première ligne de transmission hyperfréquence comprend une ligne conductrice maintenue dans le boîtier par une pièce isolante.
- La pièce isolante est surmoulée autour de la ligne conductrice.
- La pièce isolante est surmoulée à l'intérieur du boitier.
- La pièce isolante est fixée dans le boîtier au moyen d'une masse de résine.
- Le boîtier est réalisé à partir d'un matériau isolant et les surfaces conductrices du renfoncement sont métallisées, par exemple par un dépôt de nickel.
- Le boîtier comporte un premier trou, qui débouche dans la cavité et qui comporte une surface latérale conductrice qui fait partie de la première ligne de transmission hyperfréquence, et des vias métallisés sont ménagés dans le boîtier le long d'un contour fermé entourant le premier trou.
- La première ligne de transmission hyperfréquence est formée à la fois par les surfaces conductrices de la cavité et par une ligne conductrice rapportée.
- La première ligne de transmission hyperfréquence est formée uniquement par les surfaces conductrices de la cavité.
- Le composant est apte à fonctionner à des fréquences supérieures à 1 GHz.
- Le composant et/ou la carte est un dispositif moulé interconnecté.
- Le composant est un relais hyperfréquence.

L'invention sera mieux comprise et d'autres avantages de celle-ci apparaîtront plus clairement à la lumière de la description qui va suivre de trois modes de réalisation d'un ensemble comprenant un composant hyperfréquence C.M.S ainsi qu'une carte de circuit imprimé, conforme à l'invention, faite en référence aux dessins annexés dans lesquels :
- la figure 1 est une vue en perspective éclatée d'un ensemble conforme à un premier mode de réalisation de l'invention, comprenant un composant hyperfréquence monté sur une carte de circuit imprimé ;
- la figure 2 est une vue partielle en perspective éclatée, en vue de dessous, du composant représenté à la figure 1 ;
- la figure 3 est une coupe détaillée, à plus grande échelle, selon le plan PIII à la figure 1 ;
- les figures 4 à 8 sont des vues analogues à la figure 3 de cinq variantes du premier mode de réalisation ;
- la figure 9 est une vue en perspective éclatée d'un ensemble conforme à un deuxième mode de réalisation de l'invention ;
- la figure 10 est une vue partielle de dessous, en perspective, de l'ensemble de la figure 9 ;
- la figure 11 est une coupe partielle selon le plan PXI à la figure 9 ;
- la figure 12 est une coupe selon le plan PXII à la figure 11 ; et
- la figure 13 est une coupe d'un ensemble conforme à un troisième mode de réalisation de l'invention.

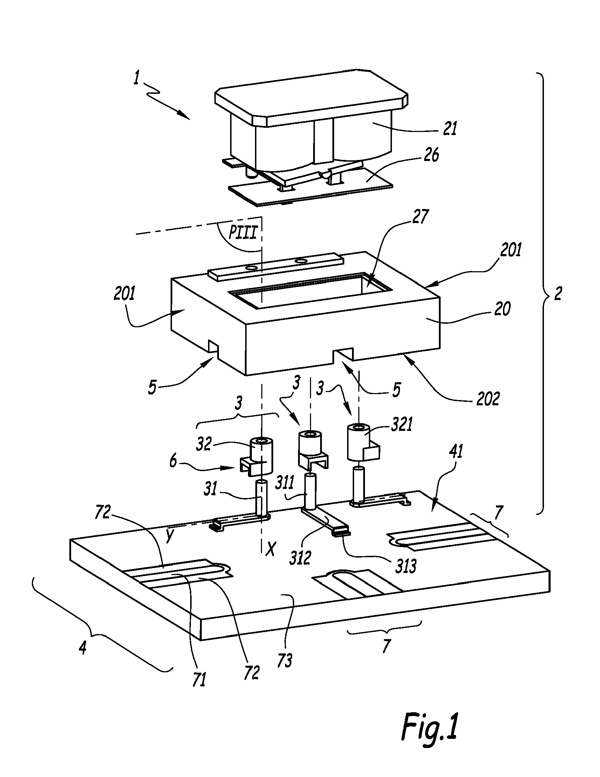

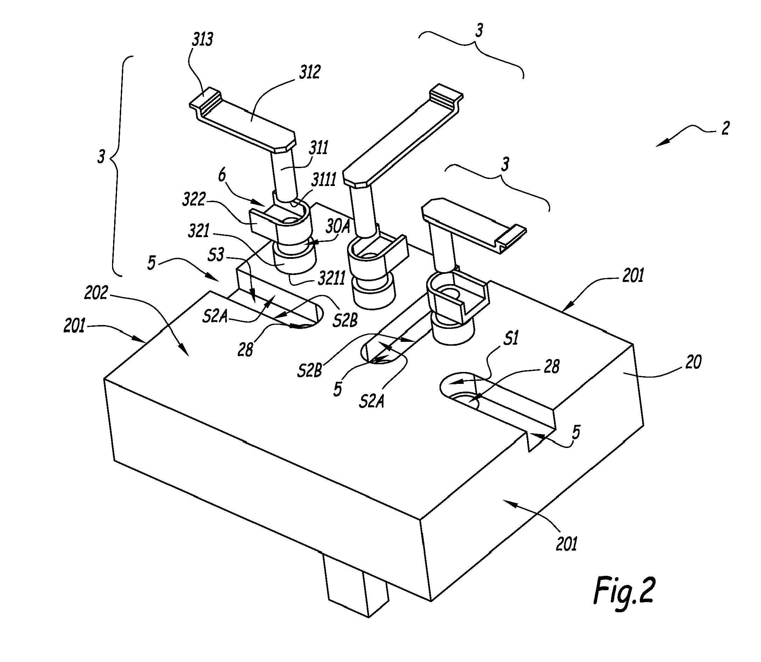

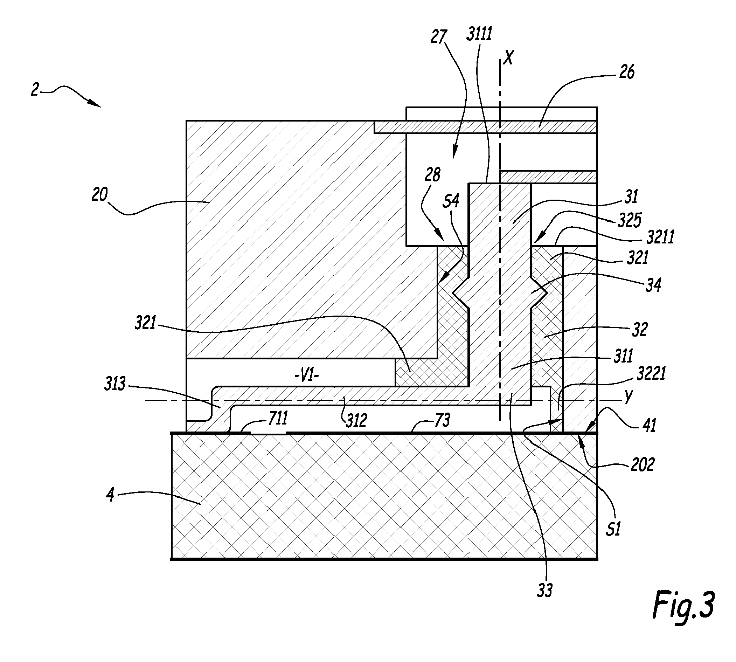

Les figures 1 à 3 montrent un ensemble 1 comprenant un composant hyperfréquence 2 et une carte de circuit imprimé 4. Dans l'exemple représenté, le composant 2 est un relais miniature, plus spécifiquement un relais SPDT (Single Pole Double Throw), dont les dimensions sont de l'ordre du cm³. Il s'agit d'un composant monté en surface (C.M.S.). En variante, il peut s'agir de tout autre composant nécessitant une bonne isolation entre ses voies coaxiales, par exemple d'autres types de relais tels qu'un relais DPDT (Double Pole Double Throw) ou plus généralement un relais nPnT (n Poles, n Throw), un coupleur, un diviseur, un filtre ou un multiplexeur.

Le relais 2 est un composant hyperfréquence, c'est-à-dire qu'il est capable de fonctionner dans la gamme des hyperfréquences, à savoir à une fréquence minimale de 1 GHz et au-delà.

En variante, l'invention s'applique aux applications de puissance hyperfréquence.

Dans la suite, les termes « haut », « bas », « vertical », « horizontal », « supérieur » et « inférieur » sont définis en relation avec l'orientation de l'ensemble 1 à la figure 1 où la carte 4 est située en bas par rapport au composant 2, qui est situé en haut. Sur cette figure, la carte 4 est orientée horizontalement. En pratique, l'orientation de l'ensemble 1 peut être différente lors de son utilisation.

Le composant 2 comprend un boîtier ou corps 20 réalisé à partir d'un matériau conducteur. Par exemple, le boîtier 20 est fabriqué par usinage ou par moulage d'un bloc d'un alliage métallique tel que le laiton. Il peut en variante être en matière plastique métallisée.

Le boîtier 20 est de forme préférentiellement parallélépipédique et comporte une face inférieure 202 horizontale prévue pour venir en contact surfacique avec une face supérieure 41 de la carte 4. D'autres formes sont possibles pour le boîtier 20.

Dans l'exemple représenté, le relais 2 comprend un élément de commutation électromagnétique 21.

Le composant 2 comporte au moins une ligne de transmission hyperfréquence 3 appelée « transition », pour l'acheminement d'un signal hyperfréquence. De préférence, le composant comporte plusieurs transitions 3. Chaque transition 3 comprend une ligne conductrice 31 appelée « contact » apte à venir en contact avec une partie active d'une voie hyperfréquence du composant 2, par exemple l'un des contacts mobiles du relais 2.

La partie fonctionnelle du composant 2 est logée dans un renfoncement 27 du boîtier 20, refermé éventuellement sur le dessus par un couvercle 26.

Le contact 31 est de forme coudée et comprend une première portion ou tige 311 verticale, terminée par une extrémité supérieure 3111, ainsi qu'une deuxième portion ou lame 312 horizontale raccordée à la tige 311, à l'opposé de l'extrémité supérieure 3111 et dont l'extrémité libre est terminée par une patte 313. La tige 311 est insérée au travers d'un trou traversant 28 appelé « traversée », ménagé dans le boîtier 20.

La tige 311 peut être de forme cylindrique à section circulaire, et s'étend le long d'un premier axe géométrique X. La lame 312 est plate et son extrémité libre ou extrémité avant, c'est-à-dire l'extrémité opposée à la tige 311, est recourbée vers le bas de manière à former la patte de contact 313 pour la connexion avec la carte 4. La lame 312 s'étend le long d'un deuxième axe géométrique Y, perpendiculaire à l'axe X. Le contact 31 est fabriqué par exemple par découpage et pliage d'une bande d'un alliage de cuivre.

Les termes « avant » et « arrière » sont définis en référence à l'orientation de l'axe Y, en considérant que l'arrière de la lame 312 est situé à proximité de la tige 311, à l'inverse de l'avant qui en est plus éloigné.

Le contact 31 est supporté par une pièce isolante, dite isolant 32, de forme coudée, qui comprend une première portion ou bague 321 verticale globalement en forme de cylindre creux à section circulaire, s'étendant le long de l'axe X. La bague 321 est logée au moins en partie dans le trou 28 du boîtier 20 et comporte un alésage central 325 centré sur l'axe X, dans lequel est logée partiellement la tige 311 du contact 31. A l'opposé de l'extrémité supérieure 3211 de la bague 321, la bague 321 est prolongée par une deuxième portion ou collerette 322 perpendiculaire à la bague 321, s'étendant le long de l'axe Y. La collerette 322 permet le guidage et le maintien mécanique du contact 31. La collerette 322 de l'isolant 32 comporte une paroi de fond ou paroi arrière 3221, deux parois latérales 323A et 323B et une paroi supérieure 324, délimitant un logement 6 ouvert vers le bas et vers l'avant, s'étendant le long de l'axe Y. A titre d'exemple, la paroi arrière 3221 est en forme de cylindre à section circulaire, dont l'axe longitudinal est confondu avec l'axe X. En variante, la paroi arrière 3221 de l'isolant 32 peut avoir une forme différente, par exemple une forme de type carrée. Les parois latérales 323A et 323B prolongent la paroi arrière 3221 et sont parallèles aux axes X et Y. La paroi supérieure 324 est perpendiculaire aux parois 3221, 323A et 323B, perpendiculaire à l'axe X et parallèle à l'axe Y.

La collerette 322 est logée dans un renfoncement 5 en forme de rainure s'étendant le long de l'axe Y et débouchant à la fois sur l'avant, sur l'une des faces latérales du boîtier 20, et vers le bas, sur la face inférieure 202 du boîtier 20. Le renfoncement 5 est refermé par le bas par la face supérieure 41 de la carte de circuit imprimé 4, de manière à définir une cavité C fermée sur les côtés et sur le dessus. Une première extrémité longitudinale du renfoncement 5 débouche sur l'une des faces latérales du boîtier 20, et une deuxième extrémité longitudinale opposée débouche sur le trou 28 de passage de l'isolant 32.

La tige 311 du contact 31 comporte un harpon périphérique 34 qui assure sa tenue dans la bague 321 de l'isolant 32. L'isolant 32 est par exemple surmoulé autour du contact 31 lorsque le contact 31 est déjà monté dans le boîtier 20.

En variante, l'isolant 32 est monté en force autour de la tige 311 du contact 31, Puis, l'ensemble formé par le contact 31 et l'isolant 32 est monté dans le trou 28 du boîtier 20.

Le renfoncement 5 comporte une paroi de fond ou paroi arrière S1, par exemple en forme de portion de cylindre à section circulaire par exemple, d'axe longitudinal X et de diamètre sensiblement égal à celui de la paroi arrière 3221 de l'isolant 32, de sorte que la paroi arrière 3221 est en contact surfacique avec la paroi arrière S1 du renfoncement 5. Le renfoncement 5 comporte deux parois latérales S2A et S2B parallèles à l'axe Y, qui prolongent la paroi arrière S1. Les parois latérales S2A et S2B sont raccordées chacune à l'une des faces latérales du boîtier 20. Le renfoncement 5 comporte également une paroi supérieure S3 qui relie les parois latérales S2A et S2B et qui peut être parallèle à la face inférieure 202 du boîtier 20.

Une zone de jonction 33 entre la première 311 et la deuxième 312 portion du contact 31 est logée dans le logement 6 de l'isolant 32. La lame 312 du contact 31 peut s'étendre dans la cavité C et peut dépasser à l'avant du logement 6.

Un volume V1 creux, qui est le volume intérieur de la cavité C, s'étend entre la lame 312 du contact 31 et la paroi supérieure S3 du renfoncement 5, d'une part, et entre la lame 312 du contact 31 et la face supérieure 41 de la carte de circuit imprimé 4, d'autre part.

Le long de l'axe Y et au niveau de la collerette 322 de l'isolant 32, le volume V1 est rempli par la matière de l'isolant 32. Le long de l'axe Y et entre la collerette 322 de l'isolant 32 et la paroi latérale du boîtier 20 sur laquelle débouche le renfoncement 5, le volume V1 est rempli par de l'air. En variante, il pourrait être rempli avec de la matière plastique isolante électriquement, dans le cas d'un surmoulage par exemple.

La carte 4 comporte au moins une ligne de transmission hyperfréquence, par exemple trois lignes 7. De préférence, la carte 4 comporte plusieurs lignes de transmission. Chaque ligne 7 est prévue pour être connectée électriquement à l'une des transitions 3 du composant 2. Ces lignes 7 peuvent être de type coplanaire, microstrip, etc.

La patte 313 du contact 31 vient en contact mécanique et électrique avec une piste centrale 71 conductrice et plane d'une ligne de transmission hyperfréquence 7, réalisée sur la face supérieure 41 de la carte 4. L'extrémité libre de la patte 313 affleure la face latérale du boîtier 20, c'est-à-dire qu'elle ne dépasse pas à l'extérieur de la cavité C, le long de l'axe Y. En variante, la patte 313 peut dépasser à l'extérieur de la cavité C pour faciliter l'examen visuel et afin d'être brasée en manuel par exemple. Dans ce cas, le plan de masse est prolongé et l'isolation améliorée. Au contraire, la patte 313 peut être légèrement en retrait à l'intérieur de la cavité C ou renfoncement 5.

La piste centrale 71 s'étend parallèlement à l'axe Y, dans le prolongement de la lame 312 de la transition 31, et dépasse en dessous de la cavité C. Plus précisément, une partie d'extrémité 711 de la piste centrale 71 peut éventuellement s'étendre au-delà de la paroi latérale du boîtier 20, sous la cavité C.

La piste centrale 71 est isolée du plan de masse 73 de la carte 4 par une partie isolante 72 en forme de U, qui est une zone dépourvue de métallisation conductrice, réalisée par exemple par gravure chimique. Les dimensions des éléments de la ligne de transmission 7 peuvent être modifiées, ce qui permet d'adapter la propagation des ondes hyperfréquence.

Lorsqu'un signal électrique est transmis par la ligne 7 à proximité du boîtier 20, le signal passe de la ligne 7 de la carte 4 à la transition 3 du composant 2, par l'intermédiaire du contact entre la patte 313 du contact 31 et une partie d'extrémité 711 de la piste centrale 71, ainsi que par l'intermédiaire du contact entre la zone conductrice 73 de la carte 4 et la zone conductrice 202 du composant 2.

Grâce aux parois S1, S2A, S2B et S3 de la cavité C, qui sont conductrices, le signal reste confiné à l'intérieur du volume V1. Sur le dessus, le signal est bloqué par la paroi arrière S1 de la cavité C. Par-dessous, le signal est bloqué par la zone conductrice 73 de la ligne 7 de la carte 4, qui referme au moins en partie le renfoncement 5 par le bas et qui est située au moins en partie sous le boîtier 20. La zone conductrice 73 ou « plan de masse » est mise à la masse. Sur les côtés, le signal est bloqué par les parois latérales S2A et S2B de la cavité C.

Le volume V1 forme ainsi une cavité C dont les parois S1, S2A, S2B, S3 et 73 sont conductrices et à la masse.

Le long de l'axe X, le signal se propage entre la tige 311 du contact 31 et la paroi métallique S4 du boîtier 20 qui délimite le trou 28, dans la matière de l'isolant 32. Cette paroi étant conductrice, le signal reste confiné et les fuites vers les autres transitions 3 sont évitées.

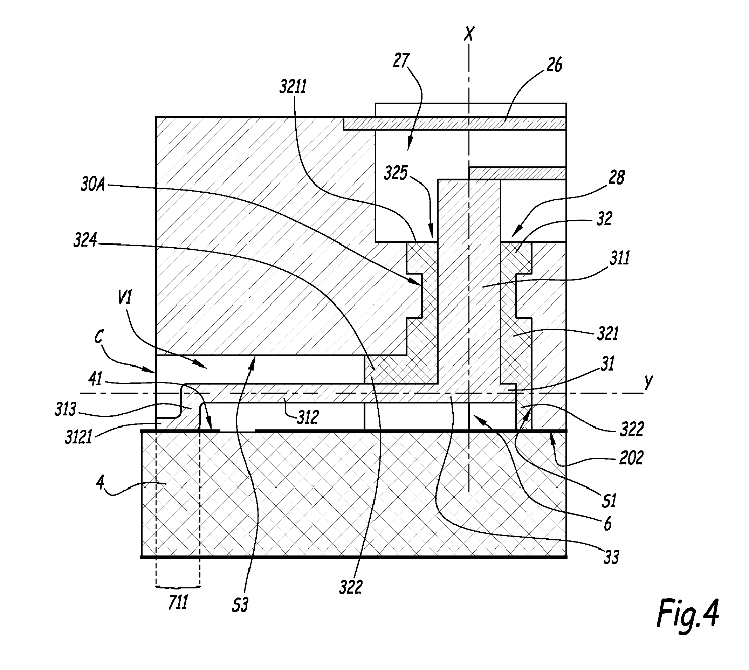

Cela permet d'utiliser l'ensemble 1 avec des signaux hyperfréquence de fréquence élevée.Les figures 4 à 8 montrent cinq variantes du composant 2, pour lesquelles les éléments semblables aux éléments correspondants du composant des figures 1 à 3 portent les mêmes références. Dans la suite, on ne décrit pas en détail les éléments des variantes similaires à ceux du composant 2 des figures 1 à 3.

La figure 4 montre une première variante du composant 2, dans laquelle la bague 321 de l'isolant 32 comporte une gorge périphérique annulaire 30A remplie par une forme complémentaire du boîtier 20, ce qui permet le maintien en position de l'isolant 32 dans le boîtier. L'isolant 32 est alors surmoulé dans le boîtier 20.

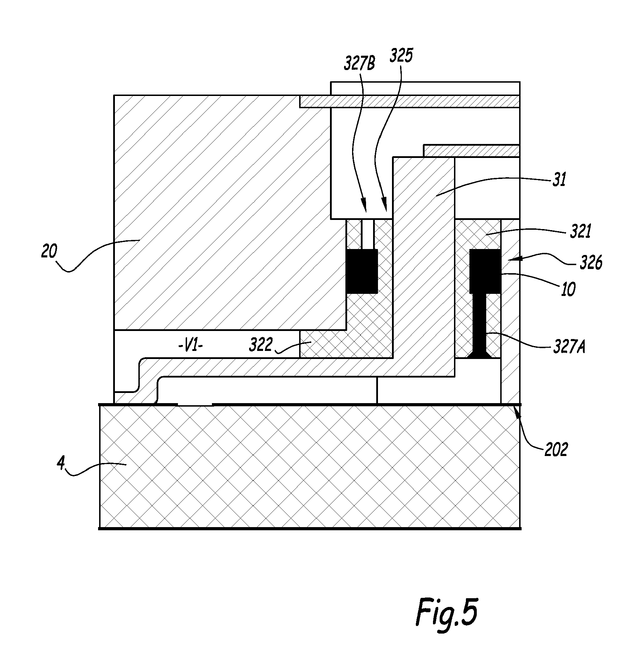

La figure 5 montre une deuxième variante du composant 2, dans laquelle la bague 321 de l'isolant 32 comporte une gorge périphérique externe 326 munie d'au moins un trou d'injection 327A et d'un trou d'évent 327B, ou inversement.

Lors de la fabrication du composant 2, le contact 31 est monté dans le trou 325 de l'isolant 32. Puis, l'ensemble formé par le contact 31 et l'isolant 32 est monté dans le trou 28 du boîtier 20. Pour immobiliser l'isolant 32 par rapport au boîtier 20, une masse de résine 10 est injectée par le trou d'injection 327A ou 327B. La résine 10 remplit la gorge périphérique 326 et l'air s'échappe par l'évent 327B ou 327A respectivement.

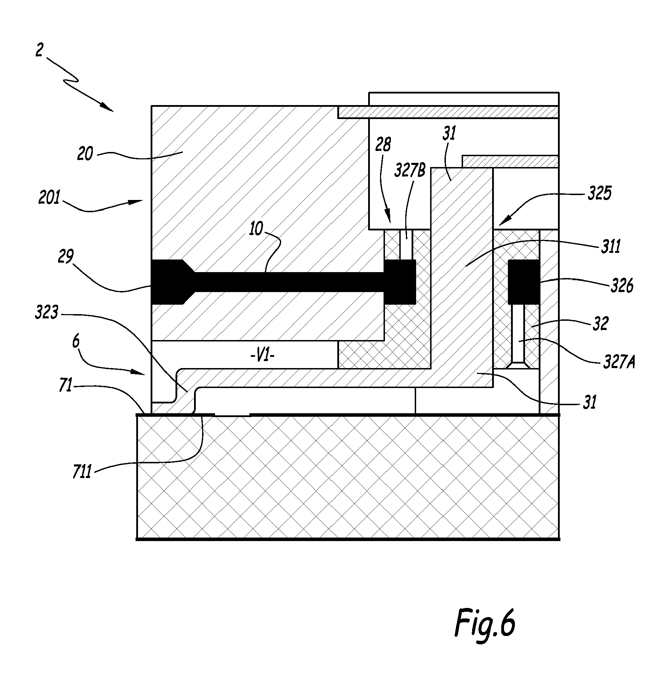

La figure 6 montre une troisième variante qui diffère de la deuxième variante en ce que le boîtier 20 comporte un trou d'injection 29 horizontal qui relie par exemple l'une des parois du boîtier 20 au trou 28.

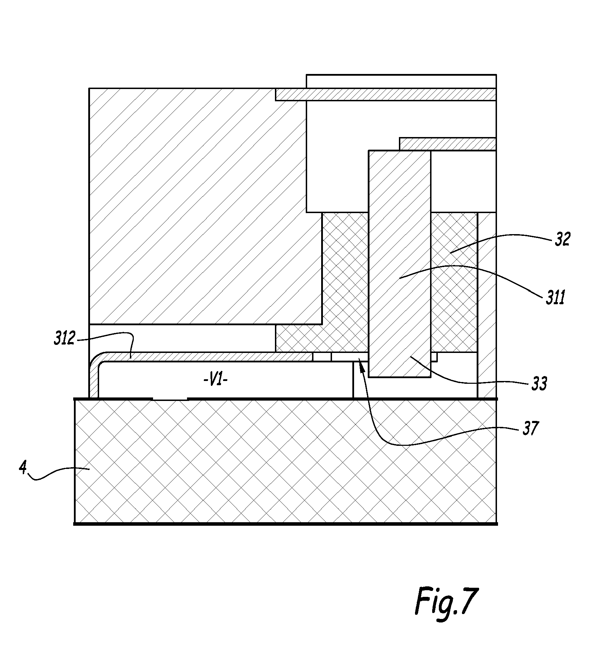

La figure 7 montre une quatrième variante du composant hyperfréquence 2, dans laquelle le contact 31 est formé par deux pièces 311 et 312 séparées. La première pièce 311 constitue la tige du contact 31, et la deuxième pièce 312 constitue la lame de la transition 31. Au niveau de la zone de jonction 33 entre les pièces 311 et 312, l'assemblage est réalisé, par exemple, grâce à une encoche 37 dans laquelle vient se loger l'extrémité inférieure de la tige 311. La fabrication d'un contact 31 bi-partite 311 et 312 est plus aisée.

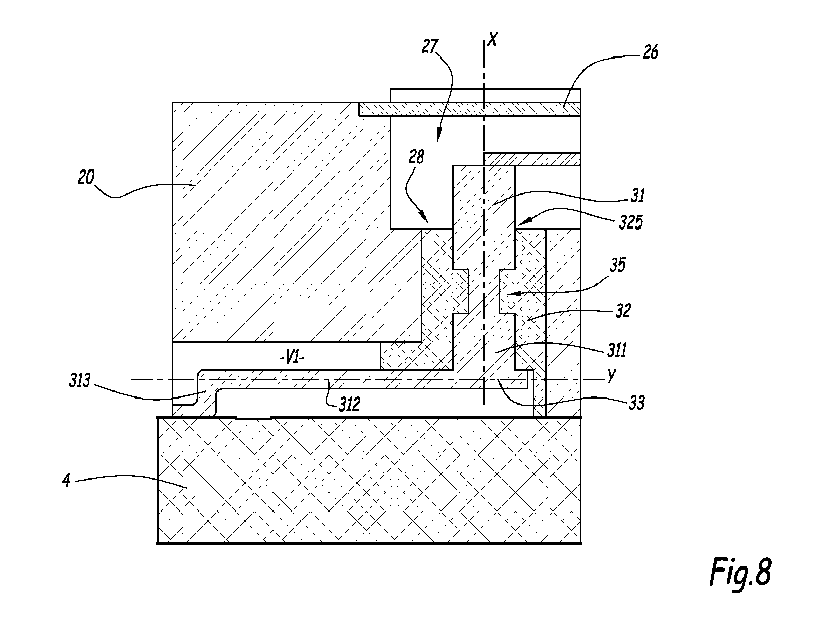

La figure 8 montre une cinquième variante du composant 2, dans laquelle la tige 311 du contact 31 comporte une gorge périphérique annulaire 35. Lors de la fabrication du composant 2, le contact 31 est mise en place dans le trou 28 du boîtier 20. Puis, l'isolant 32 est surmoulé autour du contact 31, de sorte que la matière de l'isolant 32 vient remplir la gorge 35. Puis, l'ensemble formé par le contact 31 et l'isolant 32 est monté en force dans le trou 28 du boîtier 20, de sorte que l'isolant 32 reste maintenu en position dans le boîtier 20.

Les variantes des figures 4 et 8 peuvent être combinées pour un surmoulage simultané de l'isolant 32 autour du contact 31 à l'intérieur du boitier 20.

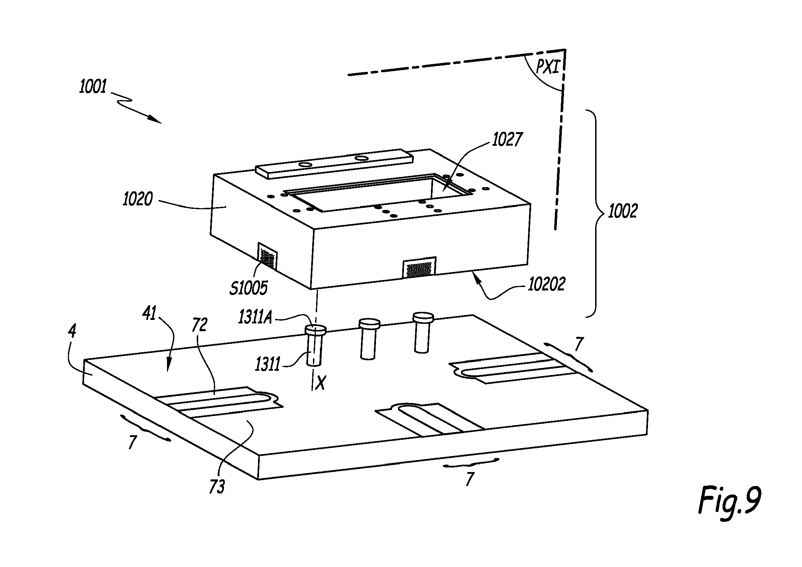

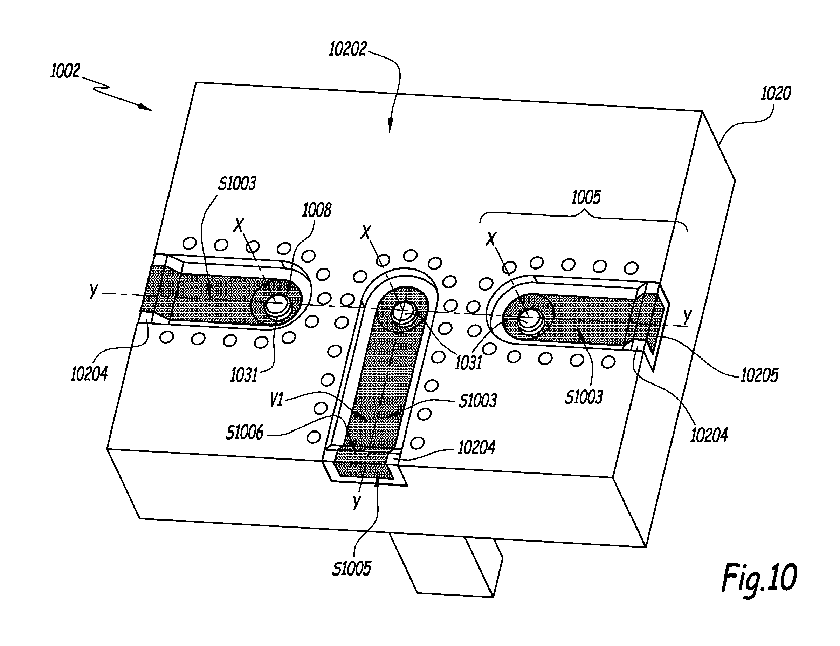

Les figures 9 à 12 montrent un ensemble 1001 conforme à un deuxième mode de réalisation de l'invention.

L'ensemble 1001 comprend un composant hyperfréquence 1002, comportant trois lignes de transmission hyperfréquence 1003, et une carte de circuit imprimé 4 analogue à celle décrite en référence aux figures 1 à 3. Les éléments du composant 1002 analogues à ceux du composant 2 des figures 1 à 3 portent les mêmes références numériques, augmentées de 1000. Dans la suite, on ne décrit pas en détail les éléments du composant 1002 similaires à ceux du composant 2.

Le composant 1002 comprend un boîtier 1020 réalisé à partir d'un matériau isolant tel qu'un polymère haute température, par exemple par injection. Le boîtier 1020 comprend au moins un trou 1028 de passage d'une tige conductrice 1311, qui peut se présenter par exemple sous la forme d'une tige cylindrique de section circulaire centrée sur un axe X et dont l'extrémité supérieure est formée par une tête 1311 A, qui peut être de diamètre supérieur. La tige conductrice 1311 est une pièce rapportée. A titre d'exemple, l'extrémité supérieure du trou 1028 est bordée par une cheminée 1028A qui fait saillie à l'intérieur d'une cavité 1027 du boîtier 1020. La tête 1031 A de la tige conductrice 1311 vient en appui sur l'extrémité supérieure de la cheminée 1028A. A l'opposé de la cheminée 1028A, l'extrémité inférieure du trou 1028 est chanfreinée et s'évase vers le bas.

Un renfoncement 1005 s'étendant le long de l'axe Y est ménagé dans une face inférieure 10202 du boîtier 1020. Le renfoncement 1005 est refermé par le bas par une zone conductrice 73 reliée à la masse de la ligne de transmission 7, de manière à former une cavité C.

Contrairement au renfoncement 5 du composant 2, la cavité 1005 ne débouche pas au niveau de la face latérale du boîtier 1020. Le boîtier 1020 comporte une paroi de fermeture 10204 qui obstrue l'extrémité avant du renfoncement 1005 et qui permet de relier la ligne de transmission 7 de la carte 4 à la transition 3 du composant 2. On note S1006 une portion conductrice de cette paroi 10204, en contact avec l'extrémité 711 de la piste conductrice 71 de la ligne de transmission 7 de la carte 4. De plus, le composant 1002 ne comporte pas d'isolant pour le maintien de la tige conductrice 1311, l'isolant étant représenté par le boitier 1020. La tige conductrice 1311 est montée directement dans le trou 1028 et vient en contact surfacique avec une paroi cylindrique S1004 du trou 1028. En outre, la tige conductrice 1311 ne comporte pas de deuxième portion ni de patte de contact.

Pour la connexion électrique entre la ligne de transmission 7 de la carte 4 et la transition 1003 du composant 1002, une paroi supérieure S1003 du renfoncement 1005 est au moins en partie métallisée afin de former une piste conductrice, par exemple par un dépôt de nickel.

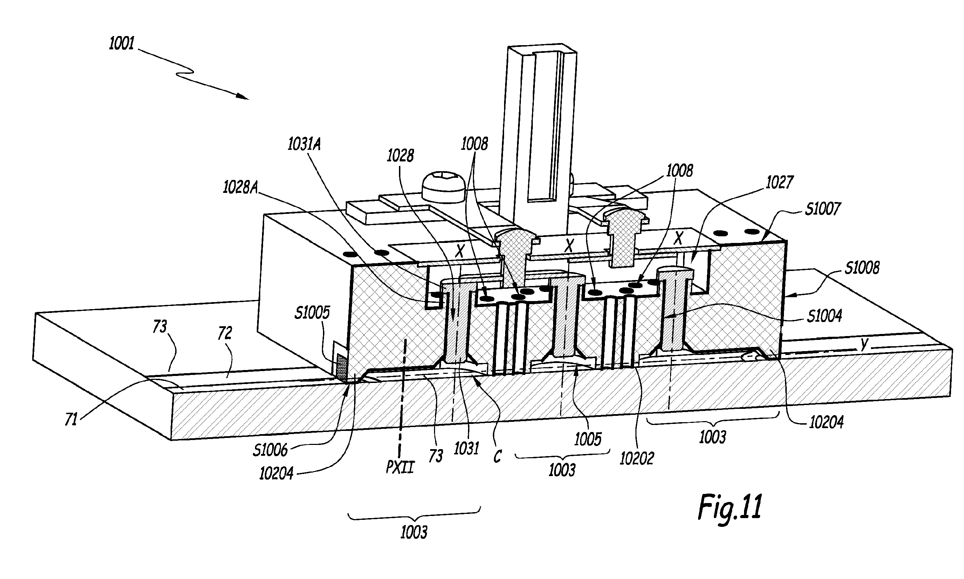

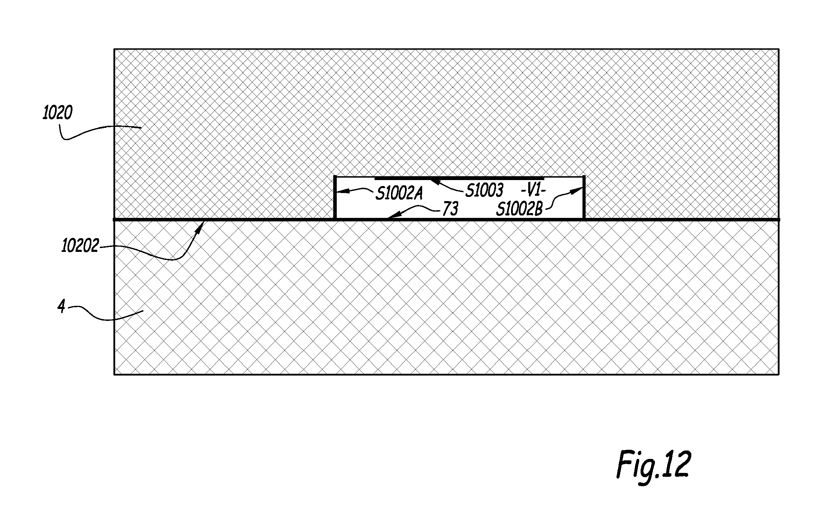

Aux figures 11 et 12, pour plus de clarté, les surfaces métallisées sont représentées en traits gras, dont l'épaisseur n'est pas représentative de l'épaisseur réelle de la couche conductrice.

La paroi S1004 du trou 1028, la portion S1006 de la paroi 10204 du boîtier 1020 en contact avec la carte 4, ainsi qu'une surface extérieure S1005 de la paroi latérale, adjacente à la carte 4, sont également métallisées, et forment des surfaces conductrices qui matérialisent la transition 1003, qui est similaire à la transition 3 du composant 2 des figures 1 à 3.

Autour de la cheminée 1028A, la paroi inférieure du renfoncement 1027 du boîtier 1020 est pourvue de trous traversants 1008 métallisés, ou « vias », parallèles à l'axe X et percés le long d'un contour fermé qui peut être circulaire et qui s'étend autour du trou 1028.

Des surfaces supérieure S1007 et latérale S1008 et une surface en dessous S10202 attenantes du boîtier 1020 sont également métallisées, et viennent en contact (directement ou indirectement dans le cas de S1007) avec le plan de masse 73 de la carte 4.

Le signal hyperfréquence est acheminé par la ligne de transmission 7 de la carte 4, à proximité du boîtier 1020, et passe de la ligne de transmission 7 de la carte 4 à la transition 1003 du composant 1002, par l'intermédiaire des surfaces métallisées S10202, S1007 et S1008 pour la masse de la ligne de transmission, et par l'intermédiaire des surfaces S1005, et S1006, du boîtier 1020 pour la partie conductrice de la ligne de transmission.

Le signal se propage ensuite, par la transition 1003, dans la cavité C qui est isolée du plan de masse 73 par le volume V1. Le signal est guidé dans la cavité blindée C par le plan de masse 73 de la carte 4 et par des surfaces latérales conductrices S1002A et S1002B du renfoncement 1005, ainsi que par les surfaces S1007 et S1008 du boîtier 1020.

Le long de l'axe X, le signal se propage autour du trou métallisé 1028 entouré par les vias 1008, qui réalisent un blindage limitant, voire empêchant, les fuites de signal entre les transitions 1003. Le trou 1028 délimite ainsi, de manière continue, la partie conductrice de passage du signal, tandis que les vias 1008 délimitent, de manière discontinue, l'extérieur ou la masse de la ligne de transmission hyperfréquence.

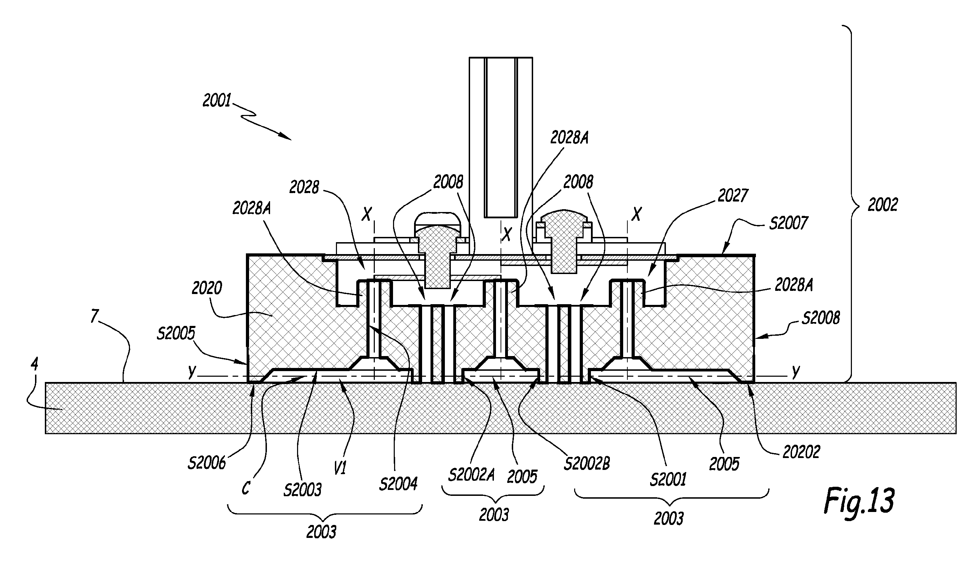

La figure 13 montre un ensemble 2001 comprenant un composant hyperfréquence 2002 conforme à un troisième mode de réalisation de l'invention, ainsi qu'une carte de circuit imprimé 4, similaire à celle des figures 1 à 3. Les éléments du composant 2002 analogues à ceux du composant 2 des figures 9 à 12 portent les mêmes références numériques, augmentées de 1000. Dans la suite, on ne décrit pas en détail les éléments du composant 2002 similaires à ceux du composant 1002.

Contrairement au composant 1002, le composant 2002 ne comporte pas de tige conductrice rapportée. Des renfoncements 2005 d'un boîtier 2020 ne débouchent pas sur des faces latérales du boîtier 2020.

Le boîtier 2020 du composant 2002 est réalisé dans un matériau isolant et des surfaces S2001, S2002A, S2002B, S2003, S2004, S2005 et S2006 des renfoncements 2005 sont métallisées, ainsi que des surface supérieure S2007 et latérales S2008 du boîtier 2020. Un trou 2028 dont l'extrémité supérieure est prolongée par une cheminée 2028A relie un renfoncement 2027 du boîtier 2020 à la cavité 2005. La surface supérieure des cheminées 2028A est métallisée, de manière à réaliser un contact électrique avec les parties actives du composant 2002. Chaque trou 2028 est entouré par des trous métallisés ou « vias » 2008 parallèles à l'axe X et percés le long d'un contour qui peut être circulaire.

Les renfoncements 2005 sont refermés par le bas par une zone conductrice 73 reliée à la masse de la ligne 7, de manière à former des cavités C. Les cavités C délimitent un volume V1 rempli d'isolant, de préférence d'air, entouré par les surfaces conductrices S2001, S2002A, S2002B, S2003, S2004 et 73

Le fonctionnement de l'ensemble 2001 est analogue au fonctionnement décrit en référence à l'ensemble 1001. A l'intérieur de la cavité C, c'est-à-dire à l'intérieur du composant 2002, le signal se propage par la transition 2003, qui est isolée du plan de masse 73 par le volume V1. Le signal est guidé dans la cavité blindée C par le plan de masse 73 et les surfaces conductrices S2001, S2002A, S2002B et également par les surfaces métallisées S2007 et S2008 qui sont à la masse. Le long de l'axe X, le signal se propage via la ligne coaxiale formée par la paroi du trou S2004 et les vias 2008 reliés à la masse et métallisés 2008 entourant le trou S2004, ce qui limite ou empêche les fuites de signal entre les transitions 2003A, 2003B et 2003C.

En variante, les ensembles 1001 et 2001 des figures 9 à 13 peuvent être réalisés à partir de la technologie M.I.D (Molded Interconnect Devices), notamment et/ou le composant 1002 ou 2002, qui sont alors dits « dispositifs moulés interconnectés ».

Dans le cadre de l'invention, les différents modes de réalisation et les variantes décrits peuvent être combinés entre eux, au moins de manière partielle. En outre, l'optimisation des performances hyperfréquences peut amener à modifier légèrement la géométrie des composants (isolants, contacts, boitiers, pistes) sans pour autant modifier le principe de l'invention. Par exemple, la cavité C peut être est délimitée par au moins une surface conductrice du boitier, qui peut être de forme courbe.

## Revendications

1. Ensemble (1 ; 1001 ; 2001) comprenant un composant (2 ; 1002 ; 2002) hyperfréquence de type composant monté en surface comportant au moins une première ligne de transmission hyperfréquence (3 ; 1003 ; 2003), ainsi qu'une carte (4) de circuit imprimé comportant au moins une deuxième ligne de transmission hyperfréquence (7) apte à être connectée à la première ligne de transmission hyperfréquence,
le composant comprenant un boîtier (20 ; 1020 ; 2020) ayant une face (202 ; 10202 ; 20202) en contact avec la carte de circuit imprimé (4),
et l'ensemble comportant au moins une cavité (C) de confinement d'un signal hyperfréquence, délimitée par :
- au moins une surface conductrice (S1, S2A, S2B, S3, S4 ; S1001, S1002A, S1002B, S1003, S1004, S1005, S1006 ; S2001, S2002A, S2002B, S2003, S2004, S2005, S2006) du boîtier, et
- une zone conductrice (73), reliée à la masse de la deuxième ligne de transmission hyperfréquence (7) ;
**caractérisé en ce que** la zone conductrice (73) de la deuxième ligne de transmission hyperfréquence (7) referme au moins en partie un renfoncement (5 ; 1005 ; 2005) du boitier, délimité par la surface conductrice pour former la cavité.

2. Ensemble (1) selon la revendication 1, **caractérisé en ce que** le boîtier (20) est réalisé à partir d'un matériau conducteur et **en ce que** les surfaces conductrices (S1, S2A, S2B, S3, S4) du renfoncement (5) sont métalliques.

3. Ensemble (1) selon la revendication 2, **caractérisé en ce que** la première ligne de transmission hyperfréquence (3) comprend une ligne conductrice (31) maintenue dans le boîtier (20) par une pièce isolante (32).

4. Ensemble (1) selon la revendication 3, **caractérisé en ce que** la pièce isolante (32) est surmoulée autour de la ligne conductrice (31).

5. Ensemble (1) selon la revendication 3, **caractérisé en ce que** la pièce isolante (32) est surmoulée à l'intérieur du boitier (20).

6. Ensemble (1) selon l'une des revendications 3 à 5, **caractérisé en ce que** la pièce isolante (32) est fixée dans le boîtier (20) au moyen d'une masse de résine (10).

7. Ensemble (1001 ; 2001) selon la revendication 1, **caractérisé en ce que** le boîtier (1020 ; 2020) est réalisé à partir d'un matériau isolant et **en ce que** les surfaces conductrices (S1001, S1002A, S1002B, S1003, S1004, S1005, S1006 ; S2001, S2002A, S2002B, S2003, S2004, S2005, S2006) du renfoncement (1005 ; 2005) sont métallisées, par exemple par un dépôt de nickel.

8. Ensemble (1001 ; 2001) selon la revendication 7, **caractérisé en ce que** le boîtier (1020 ; 2020) comporte un premier trou (1028 ; 2028), qui débouche dans la cavité (C) et qui comporte une surface latérale conductrice (S1004 ; S2004) qui fait partie de la première ligne de transmission hyperfréquence (1003 ; 2003) et **en ce que** des vias (1008 ; 2008) métallisés sont ménagés dans le boîtier (1020 ; 2020) le long d'un contour fermé entourant le premier trou.

9. Ensemble (1001) selon l'une des revendications 7 ou 8, **caractérisé en ce que** la première ligne de transmission hyperfréquence (1003) est formée à la fois par les surfaces conductrices (S1001, S1002A, S1002B, S1003, S1004, S1005, S1006) de la cavité (C) et par une ligne conductrice (1311) rapportée.

10. Ensemble (2001) selon l'une des revendications 7 ou 8, **caractérisé en ce que** la première ligne de transmission hyperfréquence (1003) est formée uniquement par les surfaces conductrices (S2001, S2002A, S2002B, S2003, S2004, S2005, S2006, 73) de la cavité (C).

11. Ensemble (1; 1001; 2001) selon l'une des revendications précédentes, **caractérisé en ce que** le composant (2; 1002 ; 2002) est apte à fonctionner à des fréquences supérieures à 1 GHz.

12. Ensemble (1; 1001; 2001) selon l'une des revendications précédentes, **caractérisé en ce que** le composant (1002 ; 2002) et/ou la carte (4) est un dispositif moulé interconnecté.

13. Ensemble (1; 1001; 2001) selon l'une des revendications précédentes, **caractérisé en ce que** le composant (2 ; 1002 ; 2002) est un relais hyperfréquence.
